# EUROPÄISCHE PATENTSCHRIFT

(11) **EP 3 210 443 B1**
(45) Veröffentlichungstag und Bekanntmachung des Hinweises auf die Patenterteilung: **16.12.2020**
(21) Anmeldenummer: 15781855.0
(22) Anmeldetag: 30.09.2015
(51) Int. Cl.: H05K 1/11, H05B 45/48, F21S 41/153, F21S 41/663

(54) **LEITERPLATTE MIT EINER MEHRZAHL VON AN DER LEITERPLATTE IN ZUMINDEST EINER GRUPPE ANGEORDNETER ELEKTRONISCHER BAUTEILE**
PRINTED CIRCUIT BOARD HAVING A PLURALITY OF ELECTRONIC COMPONENTS ARRANGED ON THE PRINTED CIRCUIT BOARD IN AT LEAST ONE GROUP
CARTE DE CIRCUIT IMPRIMÉ COMPRENANT UNE PLURALITÉ DE COMPOSANTS ÉLECTRONIQUES DISPOSÉS EN AU MOINS UN GROUPE SUR LA CARTE DE CIRCUIT IMPRIMÉ

(30) Priorität: 21.10.2014 AT 507522014
(43) Veröffentlichungstag der Anmeldung: 30.08.2017
(73) Patentinhaber: ZKW Group GmbH, 3250 Wieselburg (AT)
(72) Erfinder: WEBER, Emanuel, A-2500 Baden (AT); GRUBER, Thomas, A-2880 Kirchberg am Wechsel (AT)
(74) Vertreter: Patentanwaltskanzlei Matschnig & Forsthuber OG
(86) Internationale Anmeldenummer: PCT/AT2015/050242
(87) Internationale Veröffentlichungsnummer: WO 2016/061598

(56) Entgegenhaltungen:
- US-A1- 2011 057 569
- US-A1- 2011 193 112
- US-A1- 2014 159 598

## Beschreibung

Die Erfindung betrifft eine Leiterplatte mit einer Mehrzahl von an der Leiterplatte in mehreren Gruppen angeordneter elektronischer Bauteile, wobei die elektronischen Bauteile jeweils eine erste und eine zweite der Leiterplatte zugewandte elektrische Bauteilkontaktfläche aufweisen, wobei die Bauteilkontaktflächen mit korrespondierenden auf der Leiterplatte angeordneten Leiterplattenkontaktflächen verbunden sind, wobei aufeinander folgende elektronische Bauteile durch Serienschaltung einen Strang bilden.

Eine Mehrzahl an elektronischen Bauteilen bedeutet dabei, dass es sich um zumindest vier elektronische Bauteile handeln muss.

In einem zweiten Aspekt betrifft die Erfindung einen Scheinwerfer, insbesondere einen Kraftfahrzeugscheinwerfer, zur Erzeugung einer dynamischen Lichtverteilung.

In einem dritten Aspekt betrifft die Erfindung ein Fahrzeugscheinwerfersystem mit zwei Scheinwerfern.

Zunehmende Miniaturisierung und eine gesteigerte Leistungsdichte bei elektronischen Bauteilen haben dazu geführt, dass an Leiterplatten, an denen eine Mehrzahl elektronischer Bauelemente angeordnet ist, Flächen vorgesehen sind, die zur Kühlung der Bauteile eingerichtet sind. So gibt es vergrößerte Leiterplattenkontaktflächen, sogenannte Kontaktpads, die dazu eingerichtet sind, einerseits eine elektrische Verbindung mit einem Bauteil herzustellen und/oder Wärme von dem Bauteil in die Leiterplatte, in nachgeordnete Kühlkörper oder ein anderes benachbartes Bauteil einzuleiten. Sollte eine Mehrzahl an elektronischen Bauelementen in Serie geschaltet werden, so ist bei der Dimensionierung der Leiterplattenkontaktflächen bzw. beim Erstellen eines Leiterplattenlayouts darauf zu achten, dass diese für die Ansteuerung der Bauelemente notwendige Durchgänge für Leiterbahnen nicht verstellen bzw. versperren, sodass eine elektrische Kontaktierung bzw. Verschaltung einzelner Bauelemente möglich ist. Durch diese Leiterbahnen wird die Größe der Leiterplattenkontaktflächen im Allgemeinen deutlich eingeschränkt.

Beispielsweise offenbart das Dokument US 2011/0316009 A1 eine Beleuchtungsvorrichtung, bei welcher eine Mehrzahl an LEDs in Serie geschaltet sind, wobei die LEDs in Zeilen gruppiert sind und sämtliche LEDs einer Zeile parallel geschaltet sind. Die Serienschaltung der LEDs erfolgt von Zeile zu Zeile. Die in US 2011/0316009 A1 gezeigte Anordnung unterbindet die Möglichkeit einer separaten Ansteuerung einzelner LEDs und weist nachteilige Kühlungseigenschaften auf.

US 2011/193112 A1 und US 2011/057569 A1 offenbaren LED Modulen, wobei LEDs mit auf einer Leiterplatte angeordneten Leiterplattenkontaktflächen verbunden sind, wobei aufeinander folgende LEDs durch Serienschaltung einen Strang bilden. Diese Dokumente offenbaren nicht die Möglichkeit, die LEDs gezielt ein- und auszuschalten. US 2014/159598 A1 offenbart eine LED-Steuerschaltung, wobei gezieltes Ein- und Ausschalten von in Serien geschalteten LEDs ermöglicht ist.

Eine Aufgabe der Erfindung besteht daher darin, eine Leiterplatte mit einer Mehrzahl von an der Leiterplatte angeordneter elektronischer Bauteile zu schaffen, welche eine möglichst kompakte Anordnung der elektronischen Bauelemente an der Leiterplatte bei gleichzeitig hoher Leistungsdichte der Bauteile erlaubt und darüber hinaus robust ist und kostengünstig hergestellt werden kann.

Diese Aufgabe wird mit einer Leiterplatte nach Anspruch 1 gelöst, bei welcher der Strang wellenförmig verläuft, wobei die elektronischen Bauteile des Stranges entsprechend einer Matrix mit zumindest zwei Zeilen und zumindest zwei Spalten an der Leiterplatte angeordnet sind und der Strang entlang nebeneinander angeordneter Spalten abwechselnd auf-und abwärts verläuft.

Dank der erfindungsgemäßen Anordnung der Bauteile ist es möglich, einzelne elektronische Bauteile besonders effizient und platzsparend unter Ermöglichung einer optimierten Kühlung in Serie zu schalten. Die Bauteile sind dabei vorzugsweise in Richtung des Stranges orientiert. Das bedeutet, dass die Bauteile, die beispielsweise eine Kathode und eine gegenüberliegende Anode aufweisen, so orientiert sind, dass eine Anode oder Kathode der Kathode oder Anode des nachfolgenden Bauteils unmittelbar gegenüberliegt, sodass aufeinander folgende Bauteile vorzugsweise auf kürzestem Wege miteinander in Serie verbunden sind. Bei der Leiterplatte kann es sich grundsätzlich um eine beliebige im Stand der Technik bekannte Leiterplatte handeln, zum Beispiel einer Trägerplatine mit einem Metallkern. Die Erfindung ermöglicht eine Anordnung von elektronischen Bauteilen zur Optimierung des thermischen Haushaltes. Günstigerweise kann vorgesehen sein, dass innerhalb einer Spalte aufeinander folgende elektronische Bauteile jeweils ein in Serie geschaltetes vertikales Bauteilpaar bilden, indem jedes vertikale Bauteilpaar mit einer dem vertikalen Bauteilpaar zugeordneten gemeinsamen vertikalen Leiterplattenkontaktfläche verbunden ist. Die gemeinsame vertikale Leiterplattenkontaktfläche ist im Vergleich zu einer herkömmlichen Leiterbahn vergrößert und weist beispielsweise die doppelte, dreifache oder mehr als vierfache Breite einer Leiterbahn auf. Eine Leiterbahn ist beispielsweise zwischen 100 µm und 400 µm, vorzugsweise 250 µm breit. Eine Leiterplattenkontaktfläche weist beispielsweise eine Breite von zumindest 1000 µm, vorzugsweise 1400 µm auf. Sie erlaubt eine besonders gute Ableitung der Wärme von einzelnen elektronischen Bauteilen in die Leiterplatte oder in mit der Leiterplatte verbundene Elemente. Insbesondere ist die verbreitete Leiterplattenkontaktfläche dann von besonders großem Nutzen, wenn eines der beiden das Bauteilpaar bildenden Bauteile außer Betrieb ist, da in diesem Fall das verbleibende in Betrieb befindliche Bauteil die gesamte Kühlfläche bzw. Leiterplattenkontaktfläche für sich nutzen kann, wodurch die Kühlleistung insbesondere im dynamischen Betrieb (bei welchem einzelne Bauteile ein- und ausgeschaltet werden) besonders gesteigert werden kann.

Auch ist es vorgesehen, dass
- die elektronischen Bauteile jeder geradzahligen Spalte der obersten Zeile mit dem elektronischen Bauteil einer nachfolgenden Spalte der obersten Zeile ein horizontales Bauteilpaar bilden und die elektronischen Bauteile jeder ungeradzahligen Spalte der untersten Zeile mit dem elektronischen Bauteil der untersten Zeile einer nachfolgenden Spalte ein horizontales Bauteilpaar bilden, oder
- die elektronischen Bauteile jeder ungeradzahligen Spalte der obersten Zeile mit dem elektronischen Bauteil einer nachfolgenden Spalte der obersten Zeile ein horizontales Bauteilpaar bilden und die elektronischen Bauteile jeder geradzahligen Spalte der untersten Zeile mit dem elektronischen Bauteil der untersten Zeile einer nachfolgenden Spalte ein horizontales Bauteilpaar bilden,
indem jedes horizontale Bauteilpaar mittels einer dem horizontalen Bauteilpaar zugeordneten gemeinsamen horizontalen Leiterplattenkontaktfläche verbunden ist. Analog zu der vertikalen Leiterplattenkontaktfläche können auch die horizontalen Leiterplattenkontaktflächen eine Verbreiterung gegenüber den herkömmlichen Leiterbahnen aufweisen. So weisen diese beispielsweise die doppelte, dreifache oder mehr als vierfache Breite einer herkömmlichen Leiterbahn auf (für die horizontalen Leiterplattenkontaktflächen gelten vorzugsweise die gleichen Maßangaben wie für die vertikalen Leiterplattenkontaktflächen).

Eine Zuordnung einzelner Leiterbahnen zu den jeweiligen Leiterplattenkontaktflächen erlaubt es, die elektronischen Bauteile mit vorgebbaren elektrischen Potentialen zu verbinden, wodurch ein gezieltes Ein- und Ausschalten der einzelnen elektronischen Bauteile ermöglicht wird. Dies ändert allerdings nichts an der prinzipiellen Serienschaltung der einzelnen elektronischen Bauteile an der Leiterplatte. Ein Strang wird durch die Summe der aufeinander folgenden, miteinander elektrisch verbundenen elektronischen Bauteile gebildet.

Jeder Leiterplattenkontaktfläche ist eine Leiterbahn zugeordnet (eine Leiterbahn kann auch als sog. Stichleitung bezeichnet werden). Damit ist es möglich, die elektrischen Potentiale der Leiterplattenkontaktflächen gezielt vorzugeben und so sämtliche an den Leiterplattenkontaktflächen angebundene elektronische Bauteile gezielt ein- und auszuschalten.

In einer besonders günstigen Ausgestaltung der Erfindung kann es vorgesehen sein, dass einer Anzahl von n elektronischen Bauteilen n+1 Leiterplattenkontaktflächen zugeordnet sind. Dies erlaubt eine besonders effiziente Kühlung der einzelnen elektronischen Bauteile. Die Zahl n ist dabei eine natürliche Zahl. Jedem Bauteil ist in diesem Fall zumindest eine Kontaktfläche zugeordnet. Typischerweise ist dem ersten oder dem letzten Bauteil eines Stranges eine zweite Leiterplattenkontaktfläche zugeordnet.

Es kann besonders vorteilhaft sein, wenn die Leiterbahnen im Wesentlichen parallel zueinander verlaufen. Dadurch wird eine besonders geordnete und kompakte Anordnung der Leiterbahnen ermöglicht.

Die Leiterbahnen sind zwischen innerhalb derselben Zeile angeordneten einander gegenüberliegenden horizontalen Leiterplattenkontaktflächen herausgeführt. Dadurch kann die kompakte Anordnung der elektronischen Bauteile zusätzlich verbessert werden bzw. die Bauteildichte an der Leiterplatte weiter erhöht werden.

Die Leiterbahnen sind hin zu genau einer Seite der Leiterplatte herausgeführt. Dies ermöglicht eine besonders einfache und platzsparende Kontaktierung der elektronischen Bauteile. Dabei kann es besonders günstig sein, wenn die Leiterbahnen nur vor jeder zweiten Spalte herausgeführt sind, wodurch die Leiterplattenkontaktflächen besonders großflächig ausgestaltet werden können.

Insbesondere ist vorgesehen, dass die Leiterplattenkontaktflächen eine Fläche von zumindest 2mm², vorzugsweise von zumindest 4mm², besonders bevorzugt von zumindest 10mm², aufweisen. Dadurch wird eine besonders effiziente Kühlung der elektronischen Bauteile ermöglicht, wodurch einerseits Bauteile mit hoher Leistungsdichte eingesetzt werden können und oder Bauteile nahe aneinander angeordnet werden können.

In einer besonders vorteilhaften Ausgestaltung der Erfindung kann das elektronische Bauteil ein lichtemittierendes elektronisches Bauteil, insbesondere ein Halbleiterbauelement, besonders bevorzugt eine LED oder eine Laserdiode sein, dem vorzugsweise ein optisches Abbildungssystem nachgeschaltet ist. Dadurch ist eine besonders kompakte und/ oder effiziente Realisierung einer Leiterplatte mit lichtemittierenden elektronischen Bauteilen möglich. Bei dem optischen Abbildungssystem kann es sich beispielsweise um eine Linse, einen Reflektor oder einer Kombination aus Reflektor und Linse handeln, wobei die Linse beispielsweise als Projektionslinse ausgebildet sein kann, wobei die Projektionslinse vorzugsweise eine Abbildungslinse eines Projektionsmoduls ist. Bei der Verwendung von LEDs als lichtemittierendes elektronisches Bauteil können an der Lichtaustrittsfläche der LEDs zusätzliche Vorsatz- oder Primäroptiken vorgesehen sein. Vorzugsweise ist jedem lichtemittierenden elektronischen Bauteil jeweils eine Linse nachgeschaltet.

Günstigerweise kann das lichtemittierende elektronische Bauteil eine lichtemittierende Fläche aufweisen, wobei die lichtemittierenden Flächen benachbarter elektronischer Bauteile den gleichen Abstand zueinander aufweisen. Dadurch ist ein besonders homogenes Lichtbild, welches durch die Abstrahlung der einzelnen elektronischen Bauteile erzielt wird, gegeben.

Vorteilhafterweise kann vorgesehen sein, dass jedes elektronische Bauteil eine lichtemittierende Fläche aufweist, wobei die lichtemittierende Fläche zumindest 0, 05 mm², 0,2 mm², 0,4 mm², 0,5 mm² oder 1 mm² beträgt. Damit wird eine besonders effiziente und oder homogene Abstrahlung ermöglicht.

Die Grundfläche der elektronischen Bauteile kann beispielsweise zwischen 0,5 mm² und 10 mm² betragen, wodurch die Vorteile der Erfindung besonders gut nutzbar sind. Die Grundfläche eines elektronischen Bauteils ist dabei die der Leiterplatte zugewandte Fläche des jeweiligen elektronischen Bauteils.

Günstigerweise kann vorgesehen sein, dass die Leiterplatte eine Länge und eine Breite von jeweils zumindest 3cm, 4cm, 5cm oder 6cm aufweist.

In einer besonders kompakten Anordnung kann es vorgesehen sein, dass die elektronischen Bauteile in genau zwei Zeilen angeordnet sind. Dadurch kann die Anzahl der Leiterbahnen besonders gering gehalten werden und damit das Verhältnis von Isolierfläche zu Leiterplattenkontaktfläche besonders niedrig und daher vorteilhaft gehalten werden (der Anteil der Isolierfläche an der Gesamtfläche der Leiterplatte steigt mit einer steigenden Anzahl an Leiterbahnen, da die Leiterbahnen voneinander mittels der Isolierflächen beabstandet sind).

Alternativ dazu kann es vorgesehen sein, dass die elektronischen Bauteile in zumindest drei, vier oder mehr als vier Zeilen angeordnet sind. Dadurch kann eine besonders hohe Anzahl an elektronischen Bauteilen an einer Leiterplatte befestigt werden.

Des Weiteren kann es vorgesehen sein, dass die elektronischen Bauteile in zumindest drei, vier oder mehr als vier Spalten angeordnet sind.

Alternativ dazu kann es vorgesehen sein, dass zwischen fünf und zehn Spalten an elektronischen Bauteilen vorgesehen sind. Insbesondere kann es vorgesehen sein, dass vier Gruppen zu je 6 Spalten angeordnet sind, die zwischen zwei Gruppen mit jeweils drei Spalten angeordnet sind. Die Anzahl der seriell in einer Gruppe zu verschaltenden elektronischen Bauteile kann von der Maximalspannung der speisenden elektrischen Energiequelle abhängig sein.

Insbesondere kann es vorgesehen sein, dass zumindest zwei Gruppen vorgesehen sind, wobei die Gruppen um 180° zueinander verdreht angeordnet sind und die Leiterbahnen zwischen den horizontalen Leiterplattenkontaktfläche jeweils jener Zeile herausgeführt sind, die am weitesten von der gegenüberliegenden Gruppe beabstandet ist (also die jeweils außenliegende Zeile). Die Leiterplatte bzw. die elektronischen Bauteile innerhalb einer Gruppe können die obig genannten Eigenschaften aufweisen. Die Anordnung zweier gegenüberliegender Gruppen erlaubt es, eine besonders hohe Anzahl an elektronischen Bauteilen effizient und kompakt an einer Leiterplatte anzuordnen.

Sämtliche vorangegangene Angaben beziehen sich auf eine Gruppe. Es können einzelne Gruppen einen oder mehrere der genannten Aspekte aufweisen.

Alternativ dazu kann es ebenso vorgesehen sein, dass zumindest zwei Gruppen, vorzugsweise vier Gruppen vorgesehen sind, wobei die Gruppen um 90° zueinander verdreht angeordnet sind. Dabei ist es günstig, wenn die den einzelnen Gruppen zugeordneten Leiterbahnen sternförmig in Richtung Außenseiten der Leiterplatte verlaufen.

Um die Wirkung der Leiterplatte zusätzlich zu verbessern, kann es vorgesehen sein, dass die Leiterplatte mit einem Kühlkörper thermisch verbunden ist, wobei vorzugsweise an dem Kühlkörper ein Lüfter angeordnet ist.

Eine besonders kompakte Anordnung einzelner elektronischer Bauteile kann insbesondere bei Scheinwerfern erforderlich sein. Ein zweiter Aspekt Erfindung betrifft einen Scheinwerfer, insbesondere Kraftfahrzeugscheinwerfer, zur Erzeugung einer dynamischen Lichtverteilung, umfassend zumindest eine Leiterplatte mit daran angeordneten elektronischen lichtemittierenden Bauteilen gemäß der Erfindung, wobei es sich bei den lichtemittierenden elektronischen Bauteilen insbesondere um Halbleiterbauelemente und besonders bevorzugt um LEDs handeln kann.

Zur gezielten Beeinflussung des Lichtbildes eines solchen erfindungsgemäßen Scheinwerfers kann es vorgesehen sein, dass die elektronischen Bauelemente einzeln ansteuerbar sind.

In einem dritten Aspekt betrifft die Erfindung ein Fahrzeugscheinwerfersystem mit zwei erfindungsgemäßen Scheinwerfern, wobei der in einem in das Fahrzeug eingebauten Zustand linke Scheinwerfer auf der Fahrbahn den linken Teil der Lichtverteilung und der rechte Scheinwerfer den rechten Teil der Lichtverteilung erzeugt, und wobei zumindest jede LED-Lichtquelle, vorzugsweise jede Leuchtdiode der beiden Scheinwerfer separat ansteuerbar ist. Ein solches Fahrzeugscheinwerfersystem kann besonders leistungsstark ausgelegt und dabei trotzdem kostengünstig produziert werden.

Im Folgenden ist die Erfindung anhand beispielhafter, in den Figuren gezeigten und nicht einschränkenden Ausführungsformen näher erörtert. Darin zeigt
Figur 1 eine schematische Darstellung eines Ausschnitts einer Leiterplatte mit darin angeordneten elektronischen Bauteilen gemäß dem Stand der Technik,
Figur 2 eine schematische Darstellung eines beispielhaften elektronischen Bauteils oberhalb einer Leiterplatte,
Figur 3 eine schematische Darstellung eines Ausschnitts einer Leiterplatte mit darin angeordneten elektronischen Bauteilen gemäß einer ersten beispielhaften Ausführungsform der Erfindung,
Figur 4 eine schematische Darstellung eines Ausschnitts einer Leiterplatte mit darin angeordneten elektronischen Bauteilen gemäß einer zweiten beispielhaften Ausführungsform der Erfindung, und
Figur 5 eine schematische Darstellung eines Ausschnitts einer Leiterplatte mit darin angeordneten elektronischen Bauteilen gemäß einer dritten beispielhaften Ausführungsform der Erfindung.

Im Folgenden bezeichnen - sofern nicht anders angegeben - gleiche Bezugszeichen die gleichen Merkmale.

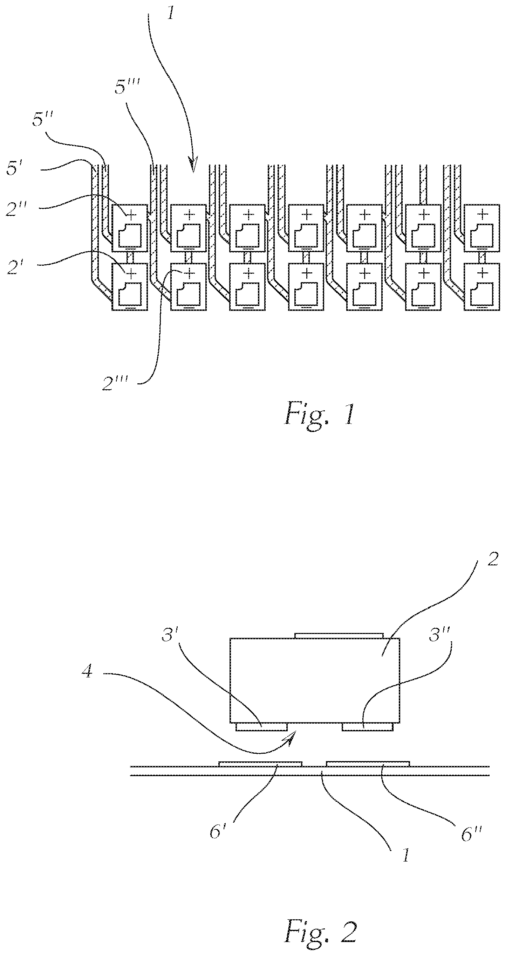

Figur 1 zeigt eine schematische Darstellung eines Ausschnitts einer Leiterplatte 1 mit darin angeordneten elektronischen Bauteilen 2 (bzw. 2', 2", 2'" usw. - das rechte Anführungszeichen " ' " dient lediglich der Nummerierung der elektronischen Bauteile, denen allesamt das Bezugszeichen 2 gemein ist) gemäß dem Stand der Technik. Zur übersichtlicheren Darstellung wurden darin nur drei elektronische Bauteile mit entsprechenden Bezugszeichen versehen. Die elektronischen Bauteile 2 weisen typischerweise einen Plus- und einen Minuspol (bzw. eine Kathode und eine Anode oder einen Kollektor und einen Emitter, Source oder Drain usw.) auf, die mit korrespondierenden Bauteilkontaktflächen 3' und 3" (siehe Fig. 2) verbunden sind.

Ein beispielhaftes elektronisches Bauteil 2, wie dieses im Stand Technik aber auch in der Erfindung eingesetzt werden kann, ist in der Figur 2 gezeigt. Darin sind einander gegenüberliegende Bauteilkontaktflächen 3', 3" erkennbar, die auf einer Grundfläche 4 des elektronischen Bauteils 2 angeordnet sind. Das elektronische Bauteil 2 ist oberhalb eines Ausschnitts einer Leiterplatte 1 angeordnet, welches zu den Bauteilkontaktflächen 3' und 3" korrespondierende Leiterplattenkontaktflächen 6' und 6" aufweist.

Die elektronischen Bauelemente 2 sind in Figur 1 entlang eines Stranges in Serie geschaltet. Hierfür sind die elektronischen Bauelemente 2 mit Leiterbahnen 5 verbunden, die die entsprechenden Bauteilkontaktflächen (in Fig. 1 nicht dargestellt) kontaktieren, indem eine erste Leiterbahn 5' einen Minuspol eines ersten elektronischen Bauteils 2' kontaktiert, eine zweite Leiterbahn 5" den Pluspol des ersten elektronischen Bauteiles 2' sowie den Minuspol des nachfolgenden elektronischen Bauteils 2" kontaktiert, eine dritte Leiterbahn 5'" den Pluspol des zweiten elektronischen Bauteils 2" sowie den Minuspol eines dritten elektronischen Bauteils 2"' kontaktiert usw. Dadurch wird eine Serienschaltung der gezeigten Bauelemente 2 erzielt, wobei zwischen den Leiterbahnen 5 liegende Isolierabschnitte einen Großteil der Fläche des gezeigten Ausschnitts der Leiterplatte ausfüllen. Bei einer solchen Anordnung kann nur eine verhältnismäßig schlechte Kühlung der elektronischen Bauteile 2 mittels der Leiterplatte 1 und/oder an der Leiterplatte 1 angeordneter Kühlelemente erzielt werden, weshalb die an der Leiterplatte 1 anbringbare Leistungsdichte der elektronischen Bauelemente 2 verhältnismäßig gering ist.

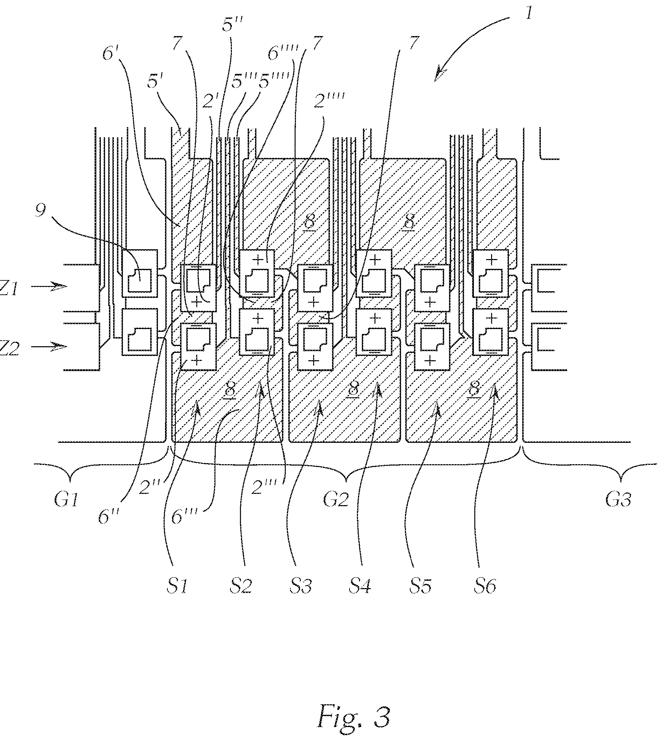

Figur 3 zeigt eine schematische Darstellung eines Ausschnitts einer Leiterplatte 1 mit darin angeordneten elektronischen Bauteilen 2 gemäß einer ersten beispielhaften Ausführungsform der Erfindung. Darin ist die Leiterplatte 1 mit einer Mehrzahl von an der Leiterplatte 1 in einer Gruppe G2 angeordneter elektronischer Bauteile 2 sowie Ausschnitte nachgelagerte analoger Gruppen G1 und G3 schematisch dargestellt. Die innerhalb dieser Gruppe G2 angeordneten elektronischen Bauteile 2 entsprechen jenen Bauteilen 2 der Figur 2 und weisen daher eine erste und eine zweite der Leiterplatte 1 zugewandte elektrische Bauteilkontaktfläche 3' und 3" auf, die mit korrespondierenden auf der Leiterplatte 1 angeordneten Leiterplattenkontaktflächen 6', 6", 6"' usw. verbunden sind, wobei aufeinanderfolgende elektronische Bauteile 2 durch Serienschaltung einen Strang bilden, wobei der Strang wellenförmig (bzw. meanderförmig) verläuft, wobei die elektronischen Bauteile 2 des Stranges entsprechend einer Matrix mit zumindest zwei Zeilen Z1 und Z2 und zumindest zwei Spalten (im ersten Ausführungsbeispiel sind in der Gruppe G2 sechs Spalten S1 bis S6 vorgesehen) an der Leiterplatte 1 angeordnet sind und der Strang entlang nebeneinander angeordneter Spalten S1 bis S6 abwechselnd auf und abwärts verläuft.

Im gezeigten Ausführungsbeispiel weist die Gruppe G2 genau sechs Spalten S1 bis S6 und zwei Zeilen Z1 und Z2 auf, in denen die elektronischen Bauteile 2 angeordnet sind. Zur übersichtlicheren Darstellung wurden nur die ersten vier elektronischen Bauteile eines Stranges mit Bezugszeichen versehen, nämlich das Bezugszeichen 2' für das erste elektronische Bauteil des Stranges, 2" für das nachfolgende elektronische Bauteil, welches in der unteren Zeile Z2 derselben Spalte S1 angeordnet ist, sowie das damit in Serie geschaltete nachfolgende elektronische Bauteil 2"' und das damit wiederum verbundene elektronische Bauteil 2"" usw.. Der Strang verläuft daher in der ersten Spalte S1 abwärts von dem ersten elektronischen Bauteil 2' zu dem zweiten elektronischen Bauteile 2", wobei, wie deutlich erkennbar ist, innerhalb einer Spalte S angeordnete aufeinanderfolgende elektronische Bauteile 2 jeweils ein in Serie geschaltetes vertikales Bauteilpaar bilden, wobei jedes vertikale Bauteilpaar mit einer dem vertikalen Bauteilpaar zugeordneten gemeinsamen vertikalen Leiterplattenkontaktfläche 7 verbunden ist. Der Übergang des Stranges von einer Spalte auf eine nachfolgende Spalte erfolgt über sog. horizontale Bauteilpaare, die durch benachbarte, innerhalb derselben Zeile angeordnete elektronische Bauteile 2 gebildet werden. Diese sind mit einer gemeinsamen horizontalen Leiterplattenkontaktfläche 8 verbunden.

Dabei gibt der Ausdruck "vertikal" nicht zwingend die geometrische Ausrichtung der Leiterplattenkontaktfläche 7 vor. Vielmehr wird damit lediglich die Verbindung von einem oberhalb angeordneten elektronischen Bauteil 2 zu einem innerhalb desselben Stranges unterhalb angeordneten nachfolgenden elektronischen Bauteil 2 beschrieben. Generell muss nicht jedes "Feld", welches Zeilen und Spalten zugeordnet ist, mit einem Bauteil 2 besetzt sein. Auch kann die Ausrichtung der Zeilen und Spalten zueinander von einer orthogonalen Struktur abweichen. Ebenso könnten einzelne Zeilen und/oder Spalten leicht versetzt sein. Vorzugweise kann die vertikale Leiterplattenkontaktfläche eine geometrische Ausgestaltung in Form eines Rechtecks aufweisen, dessen Erstreckung in eine vertikale Richtung größer ist als jene in horizontaler Richtung. Auch sind die Richtungsangaben "vertikal" und "horizontal" nur in Bezug auf die Leiterplatte 1 zu verstehen, wobei das Koordinatensystem zur Festlegung einer horizontalen und vertikalen Achse beliebig in Bezug auf die Leiterplatte 1 festgelegt werden kann. Ebenso kann die Leiterplatte 1 in beliebiger Lage, beispielweise in einem Fahrzeugscheinwerfer, eingebaut werden.

Im gezeigten Ausführungsbeispiel sind die elektronischen Bauteile 2 jeder geradzahligen Spalte (in diesem Beispiel S2, S4) der obersten Zeile (Z1) mit dem elektronischen Bauteil 2 einer nachfolgenden Spalte (S3 und S5, oberste Zeile) verbunden und bilden ein horizontales Bauteilpaar. Die elektronischen Bauteile 2 jeder ungeradzahligen Spalte (hier S3, S5) der untersten Zeile (hier Z2) sind mit dem elektronischen Bauteil 2 der untersten Zeile einer nachfolgenden Spalte verbunden und bilden ein horizontales Bauteilpaar. Dies gilt im Allgemeinen nicht für das erste und letzte elektronische Bauelement 2 des Stranges.

Natürlich kann die Verknüpfung der einzelnen Zeilen und Spalten auch in umgekehrter Weise erfolgen. In dem Beispiel gemäß der Fig. 3 verläuft der Strang zuerst die Spalte S1 abwärts dann über das horizontale Bauteilpaar der unteren Zeile Z2 zur zweiten Spalte S2, wo der Strang aufwärts Richtung Zeile Z1 verläuft, um dann wiederum die nachfolgende Spalte S3 abwärts zu verlaufen usw. Alternativ dazu könnte der Strang ebenso zuerst die Spalte S1 aufwärts verlaufen und dann über ein horizontales Bauteilpaar in die Spalte S2 überleiten und in dieser abwärts verlaufen usw. Die Verbindung der genannten elektronischen Bauteile 2 von einer Spalte zur nachfolgenden Spalte erfolgt dabei, wie bereits erwähnt, über ein horizontales Bauteilpaar, dem eine gemeinsame horizontale Leiterplattenkontaktfläche 8 zugeordnet ist. Mittels dieser Anordnung der elektronischen Bauelemente 2 wird eine Matrix geschaffen, wobei in jedem Feld dieser Matrix vorzugsweise ein elektronisches Bauteil 2 angeordnet ist. Im gezeigten Ausführungsbeispiel sind daher zwölf elektronische Bauteile 2 innerhalb der Gruppe G2 angeordnet. Die Bauteile müssen dabei nicht zwingend zueinander fluchtend in den Zeilen und Spalten angeordnet sein, sondern können durchaus zueinander versetzt werden.

In den Ausführungsbeispielen der Erfindung handelt es sich bei den elektronischen Bauelementen um LEDs, die jeweils eine Lichtaustrittsfläche 9 aufweisen, wobei in dem gezeigten Ausführungsbeispiel die Lichtaustrittsflächen 9 benachbarter elektronischer Bauteile 2 identischen Abstand zueinander aufweisen.

Außerdem ist in dem Ausführungsbeispiel gemäß Figur 3 zu erkennen, dass jeder Leiterplattenkontaktfläche 6 (sowohl die vertikalen als auch die horizontalen Leiterplattenkontaktflächen 7 und 8 werden allgemein als Leiterplattenkontaktflächen 6 referenziert) eine Leiterbahn 5 zugeordnet ist. Darüber hinaus sind einer Anzahl von (n) elektronischen Bauteilen 2 (n+1) Leiterplattenkontaktflächen 5 zugeordnet. Außerdem verlaufen die Leiterbahnen 5 im Wesentlichen parallel zueinander und sind zwischen einander gegenüberliegenden horizontalen Leiterplattenkontaktflächen 8 herausgeführt. Unter dem Ausdruck "einander gegenüberliegend" werden dabei horizontalen Leiterplattenkontaktflächen 8 verstanden, die vorzugsweise in derselben Zeile und aufeinander folgenden Spalten angeordnet sind. Dies ermöglicht es, dass die Leiterbahnen 5 hin zu genau einer Seite der Leiterplatte 1 herausgeführt werden. Außerdem sind die Leiterbahnen 5 nur vor jeder zweiten Spalte herausgeführt. Bei den sog. herausgeführten Leiterbahnen 5 handelt sich im gezeigten Beispiel im Allgemeinen um jene Leiterbahnen (5", 5"', 5""), die zwischen den horizontalen Leiterplattenkontaktflächen 8 herausgeführt sind. Wie in Figur 3 erkennbar, sind zwischen der Leiterplattenkontaktfläche 6' des ersten elektronischen Bauteils 2' und der Leiterplattenkontaktfläche 8, die mit dem vierten elektronischen Bauteil 2"" des Stranges zweiten Gruppe verbunden ist, drei Leiterbahnen (5", 5'", 5"") nach oben herausgeführt. Der Übergang der Spalten S2 und S3 weist keine nach oben oder unten herausgeführten Leiterbahnen 5 auf, wodurch die Ausbildung einer gemeinsamen horizontalen Leiterplattenkontaktfläche 8 ermöglicht wird und daher die Leiterbahnen nur vor jeder zweiten Spalte herausgeführt werden müssen. Die gezeigte Anordnung erlaubt es, Leiterbahnen hin zu dem nächsten Übergang, nämlich zwischen der Spalte S3 und S4 zu verlagern, wodurch die Gesamtanzahl der notwendigen herausgeführten Leiterbahnen einerseits reduziert und deren räumlichen Anordnung darüber hinaus optimiert werden kann. Dies erlaubt zudem eine besonders großzügige Dimensionierung der Leiterplattenkontaktflächen 6.

Die Leiterplattenkontaktflächen 6 weisen eine Fläche von zumindest 2 mm², vorzugsweise von zumindest 4 mm², besonders bevorzugt von zumindest 10 mm² auf. Die lichtemittierende Fläche 9 des elektronischen Bauteils 2 beträgt vorzugsweise zumindest 0,3 mm², bevorzugt 0,4 mm² oder zumindest 0,5 mm². Die Grundfläche eines elektronischen Bauteils 2 beträgt beispielsweise zwischen 0,5 mm² und 10 mm². Die Leiterplatte 1 kann eine Länge und/oder eine Breite von zumindest 3 cm, 4 cm, 5 cm oder 6 cm aufweisen.

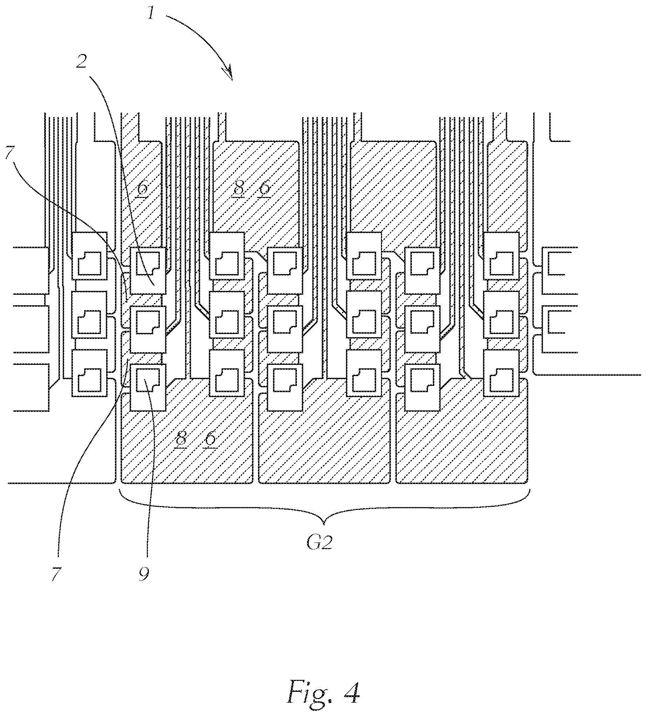

Figur 4 zeigt eine schematische Darstellung eines Ausschnitts einer Leiterplatte 1 mit darin angeordneten elektronischen Bauteilen 2 gemäß einer zweiten beispielhaften Ausführungsform der Erfindung. Die elektronischen Bauteile 2 sind darin wiederum in sechs Spalten S1 bis S6 angeordnet, wobei drei Zeilen Z1 bis Z3 vorgesehen sind. Folglich sind in der gezeigten Anordnung in der Gruppe G2 (6 x 3) achtzehn elektronische Bauelemente 2 angeordnet. Dadurch erhöht sich die Anzahl an Leiterbahnen 5, wobei analog zur ersten Ausführungsform gemäß Figur 3 nur vor jeder zweiten Spalte die Leiterbahnen 5 in der bereits beschriebenen Art und Weise nach oben herausgeführt sind. Die Angabe oben unten bezieht sich lediglich auf die Anordnung an einer Leiterplatte 1.

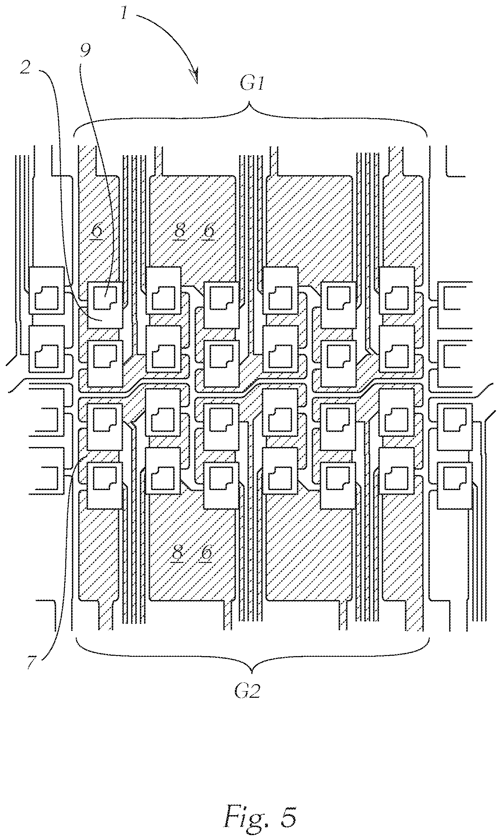

Figur 5 zeigt eine schematische Darstellung einer dritten Ausführungsform der Erfindung, in der ein Ausschnitts einer Leiterplatte 1 mit darin angeordneten elektronischen Bauteilen 2 veranschaulicht ist. Hierin ist im Wesentlichen eine Anordnung dargestellt, die in zwei Gruppen G1 und G2 gegliedert werden kann, wobei diese Gruppen einander gegenüberliegen. Die Gruppen G1 und G2 weisen zwei Zeilen und sechs Spalten auf. Jede Gruppe verfügt über zwölf elektronische Bauteile 2. Die Gruppen sind zueinander um einen Winkel von 180° verdreht, wobei aufgrund der Asymmetrie der elektronischen Bauelemente die horizontalen Leiterplattenkontaktflächen 8 so aneinander angepasst wurden, dass diese zueinander korrespondieren und einander komplementär ergänzen, wodurch eine gleichmäßige Beabstandung zwischen den Gruppen G1 und G2 sowie zwischen sämtlichen lichtemittierenden Flächen 9 der innerhalb der beiden Gruppen G1 und G2 angeordneten Bauteile 2 erzielt werden kann.

In den gezeigten Ausführungsformen sind die Abstände der lichtemittierenden Flächen 9 benachbarter elektronischer Bauelemente 2 durchgehend konstant. Alternativ dazu wäre es natürlich ebenso möglich, die Abstände zu variieren, wodurch eine gezielt Beeinflussung der Auflösung einzelner Segmente eines Lichtbildes vorgenommen werden kann.

Sämtliche der genannten erfindungsgemäßen Ausführungsformen weisen besonders vorteilhafte Kühlungseigenschaften auf und sind einfach und kostengünstig herstellbar. In Anbetracht dieser Lehre kann die Erfindung beliebiger dem Fachmann bekannter Weise abgeändert werden und ist daher nicht auf die gezeigten Ausführungsformen beschränkt. Auch können einzelne Aspekte der Erfindung bzw. der gezeigten Ausführungsformen aufgegriffen und miteinander kombiniert werden. Wesentlich sind die der Erfindung zugrunde liegenden Gedanken, die durch einen Fachmann in Kenntnis dieser Beschreibung in mannigfaltiger Weise ausgeführt werden können und trotzdem als solche aufrechterhalten bleiben.

## Patentansprüche

1. Leiterplatte (1) mit einer Mehrzahl von an der Leiterplatte (1) in zumindest einer Gruppe (G1, G2, G3) angeordneter elektronischer Bauteile (2, 2', 2", 2'", 2""), wobei die elektronischen Bauteile (2, 2', 2", 2"', 2"") jeweils eine erste und eine zweite der Leiterplatte (1) zugewandte elektrische Bauteilkontaktfläche (3', 3") aufweisen, wobei die Bauteilkontaktflächen (3', 3") mit korrespondierenden auf der Leiterplatte (1) angeordneten Leiterplattenkontaktflächen (6, 7, 8) verbunden sind, wobei aufeinander folgende elektronische Bauteile (2, 2', 2", 2"', 2"") durch Serienschaltung einen Strang bilden, wobei der Strang wellenförmig verläuft, wobei die elektronischen Bauteile (2, 2', 2", 2'", 2"") des Stranges entsprechend einer Matrix mit zumindest zwei Zeilen (Z1, Z2, Z3) und zumindest zwei Spalten (S1, ..., S6) an der Leiterplatte (1) angeordnet sind und der Strang entlang nebeneinander angeordneter Spalten (S1, ..., S6) abwechselnd auf- und abwärts verläuft, und
- die elektronischen Bauteile (2, 2"") jeder geradzahligen Spalte (S2, S4) der obersten Zeile (Z1) mit dem elektronischen Bauteil (2) einer nachfolgenden Spalte (S3, S5) der obersten Zeile (Z1) ein horizontales Bauteilpaar bilden und die elektronischen Bauteile (2") jeder ungeradzahligen Spalte (S1, S3, S5) der untersten Zeile (Z2, Z3) mit dem elektronischen Bauteil (2'") der untersten Zeile (Z2, Z3) einer nachfolgenden Spalte (S2, S4, S6) ein horizontales Bauteilpaar bilden, oder
- die elektronischen Bauteile (2) jeder ungeradzahligen Spalte (S1, S3, S5) der obersten Zeile (Z1) mit dem elektronischen Bauteil (2) einer nachfolgenden Spalte (S2, S4, S6) der obersten Zeile ein horizontales Bauteilpaar bilden und die elektronischen Bauteile (2) jeder geradzahligen Spalte (S2, S4) der untersten Zeile (Z2, Z3) mit dem elektronischen Bauteil (2) der untersten Zeile (Z2, Z3) einer nachfolgenden Spalte (S3, S5) ein horizontales Bauteilpaar bilden, indem jedes horizontale Bauteilpaar mittels einer dem horizontalen Bauteilpaar zugeordneten gemeinsamen horizontalen Leiterplattenkontaktfläche (8) verbunden ist, wobei jeder gemeinsamen Leiterplattenkontaktfläche (6, 7, 8) eine Leiterbahn (5) zugeordnet ist, wobei die gemeinsamen Leiterplattenkontaktflächen (6, 7, 8) gegenüber der Leiterbahn (5) verbreitert und zumindest 1mm breit sind, und wobei die gemeinsamen Leiterplattenkontaktflächen (6, 7, 8) eine Fläche von zumindest 2mm², vorzugsweise von zumindest 4mm², besonders bevorzugt von zumindest 10mm², aufweisen, wobei die Leiterbahnen (5) zwischen einander gegenüberliegenden, innerhalb derselben Zeile angeordneten horizontalen Leiterplattenkontaktflächen herausgeführt sind, wobei die Leiterbahnen (5) hin zu genau einer Seite der Leiterplatte (1) herausgeführt sind, wobei die Leiterbahnen (5) nur vor jeder zweiten Spalte herausgeführt sind, wobei zumindest zwei Gruppen (G1, G2) vorgesehen sind, wobei Gruppen (G1, G2)
- entweder um 180° zueinander verdreht angeordnet sind und die Leiterbahnen (5) zwischen den horizontalen Leiterplattenkontaktflächen (8) jeweils jener Zeile herausgeführt sind, die am weitesten von der gegenüberliegenden Gruppe (G1, G2) beabstandet ist,
- oder die Gruppen um 90° zueinander verdreht angeordnet sind.

2. Leiterplatte (1) nach Anspruch 1, **dadurch gekennzeichnet, dass** innerhalb einer Spalte aufeinander folgende elektronische Bauteile (2, 2', 2", 2"', 2"") jeweils ein in Serie geschaltetes vertikales Bauteilpaar bilden, indem jedes vertikale Bauteilpaar mit einer dem vertikalen Bauteilpaar zugeordneten gemeinsamen vertikalen Leiterplattenkontaktfläche (7) verbunden ist.

3. Leiterplatte (1) nach Anspruch 1 oder 2, **dadurch gekennzeichnet, dass** einer Anzahl von n elektronischen Bauteilen (2) n+1 Leiterplattenkontaktflächen (6) zugeordnet sind.

4. Leiterplatte (1) nach einem der vorhergehenden Ansprüche, **dadurch gekennzeichnet, dass** die Leiterbahnen (5) im Wesentlichen parallel zueinander verlaufen.

5. Leiterplatte (1) nach einem der Ansprüche 1 bis 4, **dadurch gekennzeichnet, dass** das elektronische Bauteil (2) ein lichtemittierendes elektronisches Bauteil, insbesondere ein Halbleiterbauelement, besonders bevorzugt eine LED ist, dem vorzugsweise ein optisches Abbildungssystem nachgeschaltet ist.

6. Leiterplatte (1) nach Anspruch 5, **dadurch gekennzeichnet, dass** jedes elektronische Bauteil (2) eine lichtemittierende Fläche (9) aufweist, wobei die lichtemittierende Fläche zumindest 0, 05 mm², 0,2 mm², 0,4 mm², 0,5 mm² oder 1 mm² beträgt.

7. Leiterplatte (1) nach einem der Ansprüche 1 bis 6, **dadurch gekennzeichnet, dass** die Grundfläche (4) der elektronischen Bauteile zwischen 0,5 mm² und 10 mm² beträgt.

8. Leiterplatte (1) nach einem der Ansprüche 1 bis 7, **dadurch gekennzeichnet, dass** die Leiterplatte (1) eine Länge und eine Breite von jeweils zumindest 3cm, 4cm, 5cm oder 6cm aufweist.

9. Leiterplatte (1) nach einem der Ansprüche 1 bis 8, **dadurch gekennzeichnet, dass** die elektronischen Bauteile (2) in genau zwei Zeilen angeordnet sind.

10. Leiterplatte (1) nach einem der Ansprüche 1 bis 9, **dadurch gekennzeichnet, dass** die elektronischen Bauteile (2) in zumindest drei, vier oder mehr als vier Zeilen angeordnet sind.

11. Leiterplatte (1) nach einem der Ansprüche 1 bis 10, **dadurch gekennzeichnet, dass** die elektronischen Bauteile (2) in zumindest drei, vier oder mehr als vier Spalten angeordnet sind.

12. Leiterplatte (1) nach einem der Ansprüche 1 bis 11, **dadurch gekennzeichnet, dass** zwischen fünf und zehn Spalten an elektronischen Bauteilen (2) vorgesehen sind.

13. Leiterplatte (1) nach einem der Ansprüche 1 bis 12, **dadurch gekennzeichnet, dass** die Leiterplatte (1) mit einem Kühlkörper thermisch verbunden ist, wobei vorzugsweise an dem Kühlkörper ein Lüfter angeordnet ist.

14. Scheinwerfer, insbesondere Kraftfahrzeugscheinwerfer, zur Erzeugung einer dynamischen Lichtverteilung umfassend zumindest eine Leiterplatte (1) nach einem vorhergehenden Ansprüche, wobei die elektronischen Bauteile (2) lichtemittierende elektronische Bauteile (2), insbesondere Halbleiterbauelemente, besonders bevorzugt eine LEDs oder Laserdioden sind.

15. Scheinwerfer nach Anspruch 14, **dadurch gekennzeichnet, dass** die elektronische Bauelemente (2) einzeln ansteuerbar sind.

16. Fahrzeugscheinwerfersystem mit zwei Scheinwerfern nach Anspruch 14 oder 15, wobei der in einem in das Fahrzeug eingebauten Zustand linke Scheinwerfer auf der Fahrbahn den linken Teil der Lichtverteilung und der rechte Scheinwerfer den rechten Teil der Lichtverteilung erzeugt, wobei zumindest jede LED-Lichtquelle, vorzugsweise jede Leuchtdiode der beiden Scheinwerfer separat ansteuerbar ist.

## Claims

1. Printed circuit board (1) comprising a plurality of electronic components (2, 2', 2", 2"', 2"") arranged on the printed circuit board (1) in at least one group (G1, G2, G3), wherein the electronic components (2, 2', 2", 2"', 2"") each have a first and a second electrical component contact surface (3', 3") facing the circuit board (1), the component contact surfaces (3', 3") being connected to corresponding circuit board contact surfaces (6, 7, 8) arranged on the circuit board (1), wherein successive electronic components (2, 2', 2", 2"', 2"") form a line by series connection, said line extending in an undulating manner, the electronic components (2, 2', 2", 2"', 2"") of the line being arranged according to a matrix with at least two rows (Z1, Z2, Z3) and at least two columns (S1, ..., S6) at the printed circuit board (1) and the strand running alternately up and down along columns (S1, ..., S6) arranged next to each other, and
- the electronic components (2, 2"") of each even-numbered column (S2, S4) of the uppermost row (Z1) forming a horizontal component pair with the electronic component (2) of a subsequent column (S3, S5) of the uppermost row (Z1), and the electronic components (2") of each odd-numbered column (S1, S3, S5) of the lowermost row (Z2, Z3) forming a horizontal component pair with the electronic component (2"') of the lowermost row (Z2, Z3) of a subsequent column (S2, S4, S6), or
- the electronic components (2) of each odd-numbered column (S1, S3, S5) of the uppermost row (Z1) forming a horizontal component pair with the electronic component (2) of a subsequent column (S2, S4, S6) of the uppermost row, and the electronic components (2) of each even-numbered column (S2, S4) of the lowermost row (Z2, Z3) forming a horizontal component pair with the electronic component (2) of the lowermost row (Z2, Z3) of a subsequent column (S3, S5),
where each horizontal component pair is connected by means of a common horizontal PCB contact surface (8) assigned to the horizontal component pair,
wherein to each common PCB contact surface (6, 7, 8) a conductor track (5) is assigned, the common PCB contact surfaces (6, 7, 8) being widened as compared to the conductor track (5) and being at least 1 mm wide, and wherein the common PCB contact surfaces (6, 7, 8) have an area of at least 2mm², preferably at least 4mm², more preferably at least 10mm², wherein the conductor tracks (5) are led out between horizontal PCB contact surfaces located opposite each other within the same row, wherein the conductor tracks (5) are led out towards exactly one side of the printed circuit board (1), wherein the conductor tracks (5) are led out in front of only every second column, wherein at least two groups (G1, G2) are provided, wherein groups (G1, G2) are
- either arranged rotated by 180° to each other and the conductor tracks (5) are led out between the horizontal PCB contact surfaces (8) of the row which is furthest away from the opposite group (G1, G2),
- or the groups are arranged rotated by 90° to each other.

2. Printed circuit board (1) according to claim 1, **characterised in that** within a column, successive electronic components (2, 2', 2", 2"', 2"") form respective series-connected vertical component pairs, with each vertical component pair being connected to a vertical PCB contact surface (7) common to and assigned to the vertical component pair.

3. Printed circuit board (1) according to claim 1 or 2, **characterised in that**, to a number of n electronic components (2), n+1 PCB contact surfaces (6) are assigned.

4. Printed circuit board (1) according to any one of the preceding claims, **characterised in that** the courses of the conductor tracks (5) are substantially parallel to one another.

5. Printed circuit board (1) according to any one of claims 1 to 4, **characterised in that** the electronic component (2) is a light-emitting electronic component, in particular a semiconductor component, more preferably an LED, to which preferably an optical imaging system is arranged downstream.

6. Printed circuit board (1) according to claim 5, **characterised in that** each electronic component (2) comprises a light-emitting surface (9), the light-emitting surface having at least 0.05 mm², 0.2 mm², 0.4 mm², 0.5 mm² or 1 mm².

7. Printed circuit board (1) according to any one of claims 1 to 6, **characterised in that** the base area (4) of the electronic components is between 0.5 mm² and 10 mm².

8. Printed circuit board (1) according to any one of claims 1 to 7, **characterised in that** the printed circuit board (1) has a length and a width, respectively, of at least 3 cm, 4 cm, 5 cm, or 6 cm.

9. Printed circuit board (1) according to any one of claims 1 to 8, **characterised in that** the electronic components (2) are arranged in exactly two lines.

10. Printed circuit board (1) according to any one of claims 1 to 9, **characterised in that** the electronic components (2) are arranged in at least three, four or more than four lines.

11. Printed circuit board (1) according to any one of claims 1 to 10, **characterised in that** the electronic components (2) are arranged in at least three, four or more than four columns.

12. Printed circuit board (1) according to any one of claims 1 to 11, **characterised in that** between five and ten columns of electronic components (2) are provided.

13. Printed circuit board (1) according to any one of claims 1 to 12, **characterised in that** the printed circuit board (1) is thermally connected to a heat sink, the heat sink preferably being provided with a fan.

14. Headlamp, in particular motor vehicle headlamp, for generating a dynamic light distribution, comprising at least one printed circuit board (1) according to any one of the preceding claims, wherein the electronic components (2) are light-emitting electronic components (2), in particular semiconductor components, more preferably an LED or laser diode.

15. Headlamp according to claim 14, **characterised in that** the electronic components (2) are individually controllable.

16. Vehicle headlamp system comprising two headlamps according to claim 14 or 15, wherein the left-side headlamp, in a state installed in the vehicle, generates the left-side part of the light distribution on the roadway and the right-side headlamp generates the right-side part of the light distribution, wherein at least each LED light source, preferably each LED of the two headlamps is individually controllable.

## Revendications

1. Carte de circuit imprimé (1) comportant une pluralité de composants électroniques (2, 2', 2", 2'", 2"") disposés sur la carte de circuit imprimé (1) en au moins un groupe (G1, G2, G3), les composants électroniques (2, 2', 2", 2'"), 2"") ayant chacune une première et une deuxième surface de contact de composant électrique (3', 3") faisant face à la carte de circuit (1), les surfaces de contact de composant (3', 3") étant connectées avec des surfaces de contact de carte de circuit (6, 7, 8) correspondantes disposées sur la carte de circuit (1), dans laquelle des composants électroniques successifs (2, 2', 2", 2'", 2"") forment un cordon par connexion en série, le cordon s'étendant de manière ondulante, les composants électroniques (2, 2', 2", 2"') 2"") du cordon étant disposées conformément à une matrice avec au moins deux lignes (Z1, Z2, Z3) et au moins deux colonnes (S1, ..., S6) sur la carte de circuit imprimé (1) et le cordon s'étendant alternativement vers le haut et le bas le long de colonnes (S1, ..., S6) disposées les unes à côté des autres, et
- les composants électroniques (2, 2"") de chaque colonne paire (S2, S4) de la ligne supérieure (Z1) formant une paire de composants horizontale avec le composant électronique (2) d'une colonne suivante (S3, S5) de la ligne supérieure (Z1), et les composants électroniques (2") de chaque colonne impaire (S1, S3, S5) de la ligne inférieure (Z2, Z3) formant une paire de composants horizontale avec le composant électronique (2"') de la ligne inférieure (Z2, Z3) d'une colonne suivante (S2, S4, S6), ou
- les composants électroniques (2) de chaque colonne impaire (S1, S3, S5) de la ligne supérieure (Z1) formant une paire de composants horizontale avec le composant électronique (2) d'une colonne suivante (S2, S4, S6) de la ligne supérieure, et les composants électroniques (2) de chaque colonne paire (S2, S4) de la ligne inférieure (Z2, Z3) formant une paire de composants horizontale avec le composant électronique (2) de la ligne inférieure (Z2, Z3) d'une colonne suivante (S3, S5),
en étant reliée chaque paire de composants horizontale au moyen d'une surface de contact PCB commune horizontale (8) associée à la paire de composants horizontale,
à chaque surface de contact PCB commune (6, 7, 8) une piste conductrice (5) étant associée, les surfaces de contact PCB communes (6, 7, 8) étant élargies par rapport à la piste conductrice (5) et ayant une largeur d'au moins 1 mm, et les surfaces de contact PCB communes (6, 7, 8) ayant une surface d'au moins 2 mm², de préférence d'au moins 4 mm², plus préférée d'au moins 10 mm², les pistes conductrices (5) étant sorties entre des surfaces de contact PCB horizontales opposées l'une à l'autre disposées dans la même rangée, les pistes conductrices (5) étant sorties vers exactement un côté de la carte de circuits imprimés (1), les pistes conductrices (5) n'étant sorties qu'avant une colonne sur deux, au moins deux groupes (G1, G2) étant prévus, et des groupes (G1, G2) étant
- soit disposés en étant tournés de 180° l'un par rapport à l'autre et les pistes conductrices (5) étant sorties entre les surfaces de contact PCB horizontales (8) de la rangée la plus éloignée du groupe opposé (G1, G2),
- soit disposés en rotation de 90° les uns par rapport aux autres.

2. Carte de circuit imprimé (1) selon la revendication 1, **caractérisée en ce que**, à l'intérieur d'une colonne, des composants électroniques successifs (2, 2', 2", 2"', 2"") forment une paire respective de composants verticaux connectés en série, chaque paire de composants verticaux étant connectée à une surface de contact PCB commune verticale (7) associée à la paire de composants verticaux.

3. Carte de circuit imprimé (1) selon la revendication 1 ou 2, **caractérisée en ce que**, à un nombre de n composants électroniques (2), n+1 surfaces de contact PCB (6) sont attribuées.

4. Carte de circuit imprimé (1) selon l'une quelconque des revendications précédentes, **caractérisée en ce que** les pistes conductrices (5) s'étendent sensiblement parallèlement les unes aux autres.

5. Carte de circuit imprimé (1) selon l'une quelconque des revendications 1 à 4, **caractérisée en ce que** le composant électronique (2) est un composant électronique émetteur de lumière, en particulier un composant semi-conducteur, de préférence une LED, qui est suivi de préférence d'un système d'imagerie optique.

6. Carte de circuit imprimé (1) selon la revendication 5, **caractérisée en ce que** chaque composant électronique (2) a une surface d'émission de lumière (9), la surface d'émission de lumière étant au moins de 0,05 mm², 0,2 mm², 0,4 mm², 0,5 mm² ou 1 mm².

7. Carte de circuit imprimé (1) selon l'une quelconque des revendications 1 à 6, **caractérisée en ce que** la surface de base (4) des composants électroniques est comprise entre 0,5 mm² et 10 mm².

8. Carte de circuit imprimé (1) selon l'une quelconque des revendications 1 à 7, **caractérisée en ce que** la carte de circuit imprimé (1) a une longueur et une largeur, respectivement, d'au moins 3 cm, 4 cm, 5 cm ou 6 cm.

9. Carte de circuit imprimé (1) selon l'une quelconque des revendications 1 à 8, **caractérisée en ce que** les composants électroniques (2) sont disposés sur exactement deux lignes.

10. Carte de circuit imprimé (1) selon l'une quelconque des revendications 1 à 9, **caractérisée en ce que** les composants électroniques (2) sont disposés sur au moins trois, quatre ou plus de quatre lignes.

11. Carte de circuit imprimé (1) selon l'une quelconque des revendications 1 à 10, **caractérisée en ce que** les composants électroniques (2) sont disposés en au moins trois, quatre ou plus de quatre colonnes.

12. Carte de circuit imprimé (1) selon l'une quelconque des revendications 1 à 11, **caractérisée en ce qu'**elle comporte entre cinq et dix colonnes de composants électroniques (2).

13. Carte de circuit imprimé (1) selon l'une quelconque des revendications 1 à 12, **caractérisée en ce que** la carte de circuit imprimé (1) est reliée thermiquement à un dissipateur de chaleur, un ventilateur étant de préférence disposé sur le dissipateur de chaleur.

14. Projecteur, en particulier projecteur de véhicule automobile, pour générer une répartition lumineuse dynamique, comportant au moins une carte de circuit imprimé (1) selon l'une quelconque des revendications précédentes, les composants électroniques (2) étant des composants électroniques (2) émettant de la lumière, en particulier des composants à semi-conducteurs, de préférence une diode LED ou une diode laser.

15. Projecteur selon la revendication 14, **caractérisé en ce que** les composants électroniques (2) peuvent être commandés individuellement.

16. Système de phares de véhicule avec deux phares selon la revendication 14 ou 15, dans lequel le phare de gauche, dans un état installé dans le véhicule, génère la partie gauche de la distribution de lumière sur la chaussée et le phare de droite génère la partie droite de la distribution de lumière, dans lequel au moins chaque source de lumière LED, de préférence chaque LED des deux phares peut être commandée séparément.
